# EUROPEAN PATENT APPLICATION

(11) **EP 1 622 207 A1**
(43) Date of publication of application: **01.02.2006**
(21) Application number: 04729225.5
(22) Date of filing: 23.04.2004
(51) Int. Cl.: H01L 33/00

(54) **LIGHT-EMITTING DIODE**

(30) Priority: 23.04.2003 JP 2003119065
(71) Applicant: HOYA CORPORATION, Shinjuku-ku, Tokyo 161-8525 (JP)
(72) Inventor: KAWAZOE, Hiroshi, Yokohama-shi, Kanagawa 247-0014 (JP); ORITA, Masahiro, Akishima-shi, Tokyo 196-0012 (JP); YANAGITA, Hiroaki, Hino-shi, Tokyo 191-0011 (JP); KOBAYASHI, Satoshi, Kunitachi-shi, Tokyo 186-0005 (JP)
(74) Representative: Becker Kurig Straus
(86) International application number: PCT/JP2004/005853
(87) International publication number: WO 2004/095591

(57) **Abstract**

A light-emitting diode with high luminous efficiency is provided which is free from deformation or defects of a crystal caused by a dopant. The light-emitting diode emits no light of unnecessary wavelengths and has a wide selection of emission wavelengths. The light-emitting diode comprises a light-emitting layer made of an ambipolar semiconductor containing no dopant, and an electron implanting electrode, that is, an n-electrode and a hole implanting electrode, that is, a p-electrode joined to the light-emitting layer.

## Description

### Technical Field

The present invention relates to a two-terminal-type light-emitting element using a semiconductor, that is, a light-emitting diode.

### Background Art

Light-emitting elements using semiconductors are widely used for displays and light sources, and have recently started to be used as illumination to replace incandescent light bulbs and fluorescent lights. A light-emitting diode is one of such light-emitting elements.

The light-emitting diode is composed of a p-type inorganic semiconductor and an n-type inorganic semiconductor joined to each other (p-n junction, an example of a prior art document is "A Guide to Optoelectronics", written by Kenya Goto, page 75, Ohm Corporation, 1981). The p-type semiconductor and the n-type semiconductor are formed by diffusing a p-type or n-type dopant into a semiconductor. The p-type dopant produces holes in the semiconductor, while the n-type dopant produces electrons in the semiconductor.

The p-n junction type light-emitting diode is manufactured by joining the p-type semiconductor and the n-type semiconductor. By applying a forward voltage to the p-n junction type light-emitting diode, the electrons existing in the n-type semiconductor are recombined with the holes existing in the p-type semiconductor at a p-n junction portion to obtain light emission.

Such a p-type semiconductor includes ZnSe doped with N (this means that Zn and Se are contained, and does not mean to specify their content rate. The same holds true for the following.), while the n-type semiconductor includes ZnSe doped with C1. These are joined to manufacture a ZnSe-based light-emitting diode (an example of a prior art document is Applied Physics Letters, vol. 57, 1990, page 2127).

### Disclosure of the Invention

In a p-n junction type light-emitting diode, in general, electric conduction sufficient for a p-type semiconductor or an n-type semiconductor can not be obtained without adding a large amount of a dopant having a concentration of 10¹⁷ /cm³ or more into an inorganic semiconductor. Thus, this dopant causes deformation, defects and the like in a semiconductor crystal, and these will be quenching centers to reduce luminous efficiency and induce emission of light of unnecessary wavelengths. Further, a conventional p-n junction type light-emitting diode is limited in a range of semiconductor materials which can be used. For example, since p-ZnS has not been developed yet, a p-n junction diode using ZnS has not been manufactured.

In order to solve the foregoing problems, the present invention provides a light-emitting diode having a configuration as follows.

The light-emitting diode according to the present invention is characterized by comprising: an electron implanting electrode, that is, an n-electrode; a hole implanting electrode, that is, a p-electrode; and a light-emitting layer disposed so as to contact these electrodes, wherein the light-emitting layer is an ambipolar inorganic semiconductor having both an electron transport property and a hole transport property.

Because this ambipolar inorganic semiconductor does not contain a dopant to obtain a desired polarity unlike the conventional p-n junction type light-emitting diode described above, the deformation or defect of a crystal structure is not induced. Thus, problems such as a reduction in the luminous efficiency due to the quenching centers and the emission of the light of unnecessary wavelengths are not induced. Moreover, since this is not a light-emitting diode composed by using both the p-type semiconductor and the n-type semiconductor, the light-emitting diode of the present invention can be manufactured even if a semiconductor is used in which the p-type semiconductor or the n-type semiconductor does not exist. For example, a light-emitting diode using ZnS can be realized.

### Brief Description of the Drawings

FIG. 1 is a sectional view showing a structure of a light-emitting diode which is one embodiment according to the present invention;
FIG. 2 is a sectional view showing a structure of a conventional light-emitting diode;

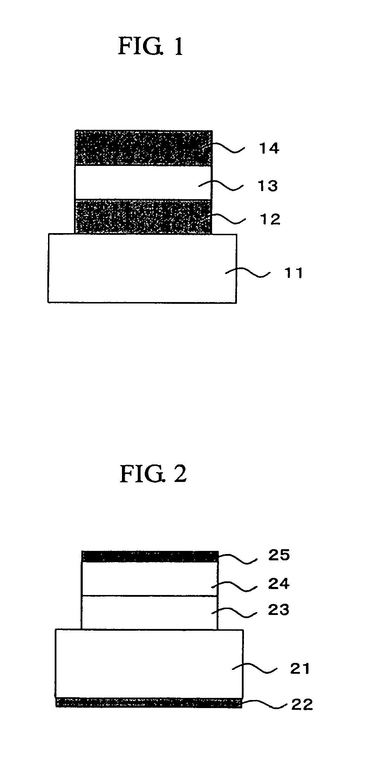

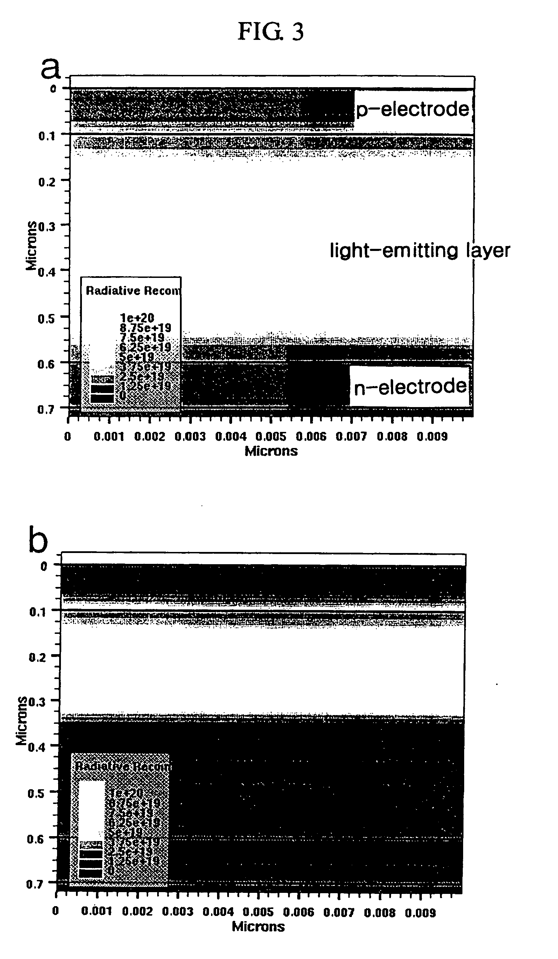

FIG. 3 is a diagram gradationally showing results of examining by simulation a recombination emission speed in the light-emitting diode shown in FIG. 1 in a range of 0 to 1 × 10²⁰ /scm³, wherein diagrams a and b are shown among four diagrams a to d corresponding to hole mobility, and the diagrams a to d show a section of the light-emitting diode in which a horizontal axis indicates a width of the element along a direction parallel with a substrate surface, and the width of the element is 10 nm in each case, while a vertical axis indicates a thickness of the element along a direction vertical to a substrate;
FIG. 4 shows diagrams c and d among the four diagrams a to d in the same manner as FIG. 3;
FIG. 5 is a diagram showing results of examining by simulation a voltage/current characteristic of the light-emitting diode shown in FIG. 1, wherein a horizontal axis indicates a voltage (V) applied to an anode, and a vertical axis indicates an anode current (A);
FIG. 6 is a block diagram of a time of flight measurement device used in (Example 1);
FIG. 7 shows a voltage/current curve of the light-emitting diode manufactured in (Example 2);
FIG. 8 shows an emission spectrum of the light-emitting diode manufactured in (Example 2), wherein a indicates the emission spectrum of the light-emitting diode of the present invention, and b indicates the emission spectrum of a p-n junction type light-emitting diode manufactured as a comparative example;
FIG. 9 is a sectional view showing a structure of a light-emitting diode which is one embodiment according to the present invention;
FIG. 10 is a sectional view showing a structure of a light-emitting diode in (Example 3); and
FIG. 11 is a sectional view showing a structure of a light-emitting diode in (Example 6).

### Advantage of the Invention

According to the present invention, since a dopant is not introduced into a light-emitting layer, crystal growth can be achieved with low defect density, and a light-emitting diode capable of performing efficient light emission can be provided which is free from a reduction in luminous efficiency due to the dopant and from emission of light of unnecessary wavelengths due to the dopant. Further, since it is possible to use diamond, a group II-VI compound semiconductor, a group III-V compound semiconductor or the like as the light-emitting layer, mobility is high, thereby allowing not only sufficient emission intensity to be obtained, but also an emission wavelength to be selected in a wide range from ultraviolet light to infrared light. Moreover, since a p-type semiconductor and an n-type semiconductor are not needed, a semiconductor difficult to convert into a p type or an n type can be used for the light-emitting layer to manufacture the light-emitting diode. Still further, since not only a monocrystalline but also polycrystalline or amorphous substrate can be employed as the substrate, a glass substrate, a plastic substrate and the like can be used, and moreover, a transparent substrate can be used, so that the present invention enables manufacture of a large-area light-emitting device.

### Best Mode for Carrying out the Invention

An embodiment of the present invention will hereinafter be described in detail with reference to the drawings.

### (1) Structure

FIG. 1 is a diagram showing a structure of a light-emitting diode which is one embodiment of the present invention. In the light-emitting element of the present invention, an n-electrode 12 is formed on a substrate 11, and an ambipolar inorganic semiconductor 13 which is a light-emitting layer is stacked on the n-electrode 12, and a p-electrode 14 is further stacked on the ambipolar inorganic semiconductor 13. The n-electrode and the p-electrode here may be interchanged. That is, the ambipolar inorganic semiconductor may be formed on the p-electrode, and the n-electrode may further be stacked on the ambipolar inorganic semiconductor.

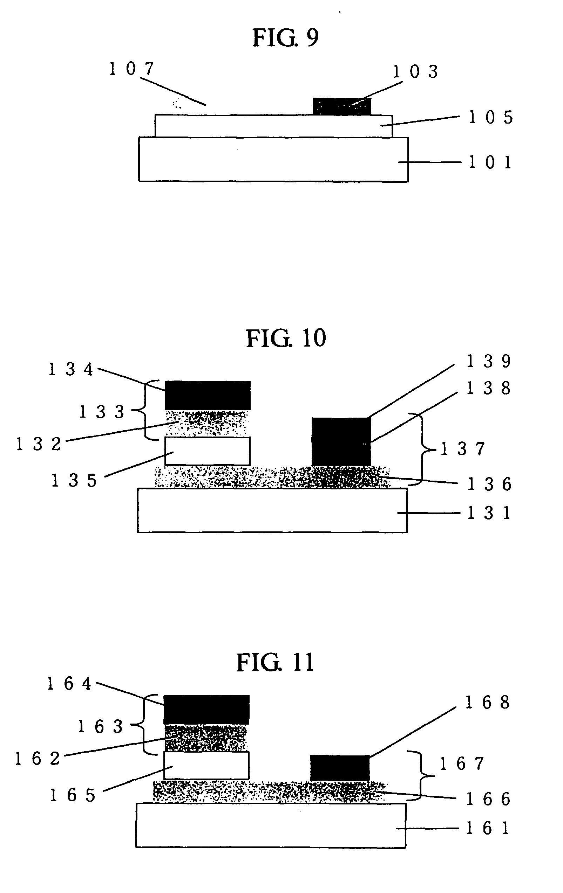

Furthermore, an embodiment of the light-emitting element of the present invention also includes a light-emitting diode as in FIG. 9. An ambipolar inorganic semiconductor 105 which is a light-emitting layer is formed on a substrate 101, and an n-electrode 103 and a p-electrode 107 are formed on the light-emitting layer 105 in a state contacting the light-emitting layer and in a state not to contact each other.

In the light-emitting diode of the present invention, a material used for the n-electrode is a metal which allows electrons to be implanted into the light-emitting layer or a semiconductor, or a combination of a metal layer and a semiconductor layer. A material used for the p-electrode is a metal or a semiconductor or a combination of a metal layer and a semiconductor layer which allows holes to be implanted into the light-emitting layer. Generally, the materials used for the electrodes and the material used for the light-emitting layer may be different.

FIG. 2 is a diagram showing an exemplary structure of a conventional p-n junction type light-emitting diode. A p-type semiconductor 23 and an n-type semiconductor 24 are stacked on a conductive substrate 21, and metal electrodes 22 and 25 are formed on a lower surface of the conductive substrate 21 and an upper surface of the n-type semiconductor 24. Generally, the p-type semiconductor and the n-type semiconductor use the same semiconductor as a host crystal.

### (2) Overall Operation

An overall operation will be described below referring to FIG. 1.

When a potential positive to a potential of the n-electrode 12 is applied to the p-electrode 14, electrodes and holes are implanted into the light-emitting layer 13 from the n-electrode 12 and the p-electrode 14, respectively. The electrodes and holes in the light-emitting layer 13 recombine with each other, and emit light of a wavelength corresponding to an inter-band-edge energy difference of the ambipolar inorganic semiconductor forming the light-emitting layer 13. Alternatively, when excitons are stable in the light-emitting layer 13, light of a wavelength corresponding to binding energy of the excitons is emitted.

As described above, in the light-emitting diode of the present invention, the electrodes and holes which are a light-emitting source are implanted into the light-emitting layer from the outside via all the electrodes. Therefore, it is not necessary to dope the light-emitting layer.

### (3) Details of Each Component (Function, Material, Manufacturing Method, Etc.)

Each component of the light-emitting diode of the present invention will be described below in greater detail.

### . Substrate

The substrate becomes a foundation of the respective layers formed thereon. A combination of the substrate and the light-emitting layer can be selected considering a crystal system (monocrystal/polycrystal/amorphism) and a lattice constant of the light-emitting layer.

For example, when the light-emitting layer is monocrystalline, it is preferable to employ a monocrystalline substrate as the substrate and manufacture the light-emitting layer by epitaxially growing it on the monocrystalline substrate. At this time, it is preferable that lattice constants of a crystal forming the light-emitting layer and a crystal of the substrate are equivalent. Further, if a monocrystalline light-emitting layer can be formed, a glass substrate may be used as the substrate.

Furthermore, when the light-emitting layer is polycrystalline or amorphous, it is not necessary to use the monocrystalline substrate as the substrate, and for example, the glass substrate or a plastic substrate can be used. The glass substrate and the plastic substrate make it possible to easily and inexpensively obtain a substrate of a large size (e.g., several ten cm square or more) as compared with the monocrystalline substrate, and they are less toxic and are therefore excellent as a substrate material. Especially, the plastic substrate is preferable in that it is light, impact-resistant and flexible.

Combinations of the material of the light-emitting layer and the substrate include, for example, the following combinations.

When ZnS is used for the light-emitting layer, it is possible to use a ZnS monocrystalline substrate, a GaP monocrystalline substrate, an Si monocrystalline substrate, a sapphire substrate, the glass substrate, the plastic substrate or the like.

When ZnSe is used for the light-emitting layer, it is possible to use a ZnSe monocrystalline substrate, a GaAs monocrystalline substrate, the Si monocrystalline substrate, the sapphire substrate, the glass substrate, the plastic substrate or the like.

When GaN is used for the light-emitting layer, it is possible to use a GaN monocrystalline substrate, an SiC monocrystalline substrate, the Si monocrystalline substrate, the sapphire substrate, the glass substrate, the plastic substrate or the like.

When SiC is used for the light-emitting layer, it is possible to use the SiC monocrystalline substrate, the Si monocrystalline substrate, the sapphire substrate, the glass substrate, the plastic substrate or the like.

When C (diamond) is used for the light-emitting layer, it is possible to use a diamond monocrystalline substrate or the like.

When amorphisms of various ambipolar inorganic semiconductors are used for the light-emitting layer, it is possible to use the glass substrate, the plastic substrate or the like.

It is to be noted that the substrate may serve as both the p-electrode and the n-electrode in the present invention.

### . Light-emitting Layer

The ambipolar inorganic semiconductor is used for the light-emitting layer. Here, it is preferable that the semiconductor does not have deformation or defects and do not contain impurity ions such as the dopant. By using such a nondefective high-purity inorganic semiconductor, it is possible to eliminate a quenching center from a light-emitting portion, restrain emission of light of unnecessary wavelengths from being induced and restrain a reduction in luminous efficiency.

Here, the semiconductor must have ambipolarity. The ambipolar semiconductor is a semiconductor which simultaneously has an electron transport property and a hole transport property. The ambipolarity can be measured by, for example, a time of flight method based on pulse photoexcitation. When the semiconductor does not have the ambipolarity, that is, when it does not have the transport property of at least one of the electrons and holes, a recombination phenomenon of the electrons and holes can not be induced in the semiconductor, and the semiconductor can not be used as an effective light-emitting layer. The electrons and holes implanted into the ambipolar semiconductor recombine with each other in the semiconductor, and generally emit light corresponding to an inter-emission-level energy difference.

The electron transport property and the hole transport property are preferably on about the same level in order to efficiently cause the recombination at the midpoint between the n-electrode and the p-electrode. If mobility of the electrons and mobility of the holes are extremely different, the recombination of these carriers is caused at an interface between the electrode and the light-emitting layer, and it becomes difficult to obtain sufficiently high luminous efficiency. This is because in general, impurities are mixed into the light-emitting layer and crystallinity of the light-emitting layer deteriorates in a process of joining to the electrode layer in the vicinity of the interface. Therefore, in the present invention, an influence of a ratio of mobility of both the carriers exerted on the light-emitting portion in the light-emitting layer was inspected, and a preferable range of the ratio of mobility was clarified.

Regarding the light-emitting diode of the present invention, the preferable range of the ratio of mobility was examined by a simulation calculation. A semiconductor simulator BLAZE manufactured by Silvaco Japan was used for the calculation, and a section of the light-emitting diode shown in FIG. 1 was divided in a lattice form for a two-dimensional model, and then Poisson's equation and an electric current equation of continuity were simultaneously solved at each lattice point.

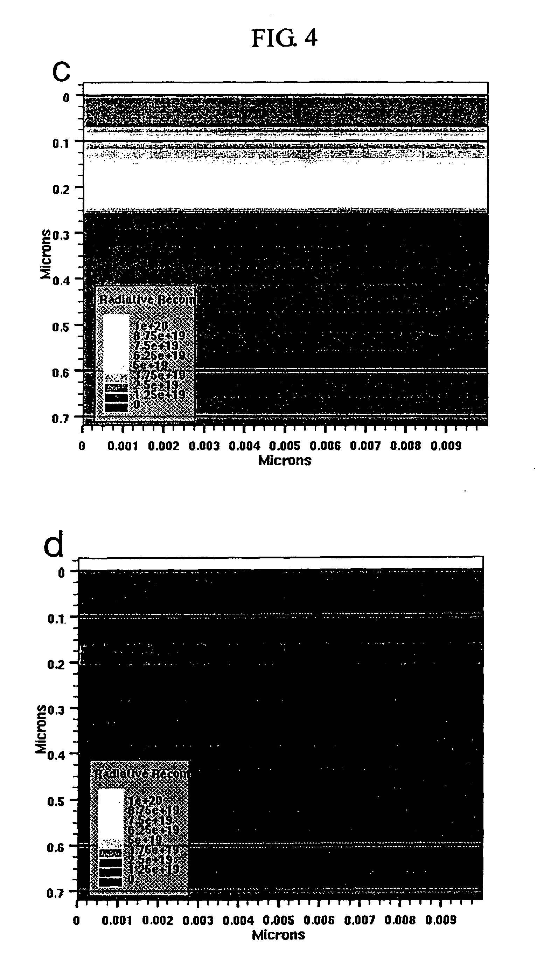

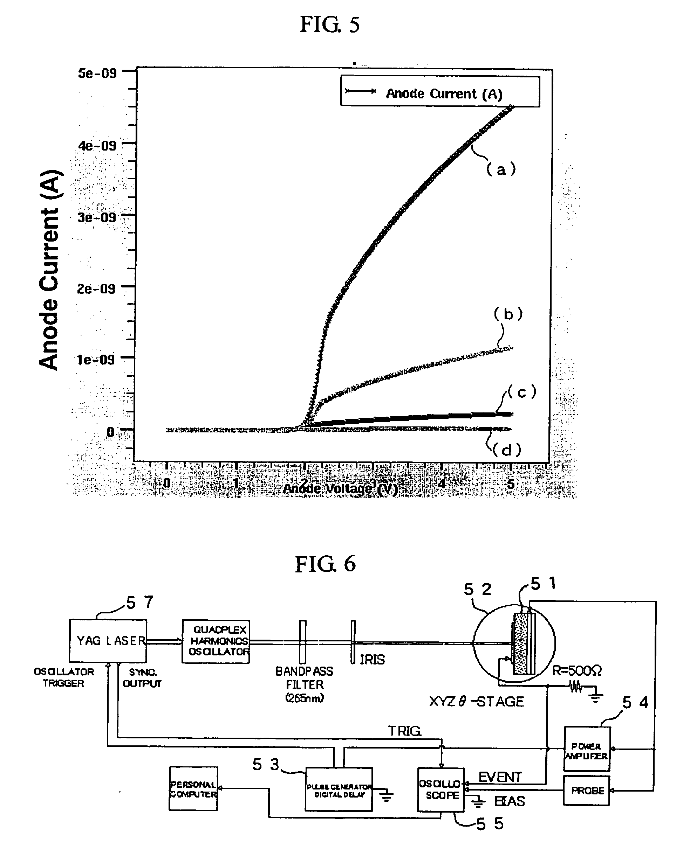

Section models of the light-emitting diode used for the calculation are shown in FIGS. 3 and 4. The substrate material is GaAs. It has a structure in which n-ZnSe is deposited 100 nm as the n-electrode, and ZnSe is stacked 500 nm as the light-emitting layer, and moreover, p-ZnSe is stacked 100 nm as the p-electrode. A metal electrode which makes an ohmic connection with the n-electrode is affixed to the interface between the substrate and the n-electrode, and a metal electrode which makes an ohmic connection with the p-electrode is affixed to a surface of the p-electrode. Density of an n-dopant and a p-dopant in both the electrodes is 1 × 10¹⁸ /cm³, and it was assumed that one dopant produces one carrier. In every layer, the mobility of the electrons is fixed to 20 cm²/Vs. The mobility of the holes is 20 cm²/Vs in FIG. 3a, 5 cm²/Vs in FIG. 3b, 1 cm²/vs in FIG. 4c, and 0.1 cm²/Vs in FIG. 4d.

In FIGS. 3 and 4, results of calculating a recombination emission rate are gradationally (brightness) shown in a range of 0 to 1 × 10²⁰ /scm³. Thus, it is possible to view the light-emitting portion in the section of the light-emitting diode, wherein the recombination emission rate is higher in whiter areas. It is apparent that as the mobility of the holes decreases when compared with the mobility of the electrons, the light-emitting portion is displaced from a central position between the electrodes, and moves to the p-electrode side.

From these examination results, the ratio of mobility is preferably closer to 1. It is specifically 1/100 to 100. It is more preferably 1/10 to 10. Experimentally, the mobility can be measured by an ordinary Hall effect measurement or by the time of flight method based on the pulse photoexcitation.

To obtain emission intensity, the mobility of both the electrons and holes of the semiconductor is preferable to be high. If the mobility is low, an electron current or a hole current in the semiconductor becomes too low, and the sufficiently high luminous efficiency can not be obtained.

In the above calculation, part of results of examining a relation between the mobility and the current is shown in FIG. 5. A horizontal axis indicates a voltage (V) applied to an anode, and a vertical axis indicates an anode current (A). However, a width in an x-axis direction of the diode is 10 nm, and a width in a z-axis direction (direction to an inner side of the drawing) is 1 µm. Therefore, current density per cm² can be obtained by increasing a value in the graph 10¹¹ times. Alphabets indicated in the graph correspond to a set of mobilities of both the carriers illustrated in FIGS. 3 and 4. That is, in all cases in the graph, the electron mobility is 20 cm²/Vs. In a case of a, the hole mobility is 20 cm²/Vs, and the current density when 5 V is applied is 450 A/cm². As the mobility of the holes decreases, a current value is reduced. This corresponds to the fact that the emission intensity is reduced as the mobility of the holes decreases in FIGS. 3 and 4. In a case of d, the hole mobility is 0.1 cm²/Vs, and the current density when 5 V is applied is 2.4 A/cm². Further, when both the electron mobility the hole mobility are set at 0.1 cm²/Vs, the obtained current value is lower. It is possible to judge from this that light emission with practical intensity can not be expected when the mobility of the carriers is 0.1 cm²/Vs or less.

From these examination results, the mobility of the carriers is preferably higher. Specifically, it is preferably 0.1 cm²/Vs or more, more preferably 1 cm²/Vs or more, and still preferably 10 cm²/Vs or more.

The mobility of the carriers influences a distance between the n-electrode and the p-electrode. If the mobility of both the carriers is sufficiently high, the carriers implanted from both the electrodes move in the ambipolar inorganic semiconductor and can recombine with each other, so that a wide distance between both the electrodes can be secured. The inter-electrode distance is suitably 10 nm to 10 µm. If the inter-electrode distance is 10 nm or less, a recombination position of both the carriers is too close to the interface between the electrode and the light-emitting layer, it is more susceptible to disturbance of a crystal structure at the interface. On the other hand, if the inter-electrode distance is 10 nm or more, the element becomes highly resistive, and a sufficient current can not be injected. As in FIG. 1, when the n-electrode, the light-emitting layer and the p-electrode are sequentially stacked to produce the element, the inter-electrode distance is decided by a thickness of the light-emitting layer.

A specific resistance value of the ambipolar inorganic semiconductor at room temperature is preferably high. Carriers do not originally exist in the ambipolar inorganic semiconductor, and it is ideal that carriers implanted from the n-electrode and the p-electrode alone move in the ambipolar inorganic semiconductor. Here, the original carriers are holes or electrons generated by the defects or impurity ions (including the dopant) existing in the ambipolar inorganic semiconductor. Therefore, that fact that the specific resistance value is high means that a crystal has good quality with few defects, and also means that the crystal does not contain the impurity ions. Specifically, the specific resistance value at room temperature is preferably 10⁸ Ωcm or more. More preferably, it is 10¹⁰ Ωcm or more. If a DC specific resistance value is 10⁸ Qcm or less, density of the carriers generated by the defects or impurity ions will be high, and the ratio of the carriers implanted from the n-electrode and the p-electrode will be relatively low, thus hindering controllability of the light-emitting element.

It is not proper to use an ordinary DC resistance measurement method such as a four-terminal method for the measurement of the specific resistance value. When a work function of a metal electrode to be used is sufficiently low to be able to implant electrons into the ambipolar inorganic semiconductor or sufficiently high to be able to implant holes, the carrier density in the ambipolar inorganic semiconductor is controlled by the carriers flowing from the electrode. Thus, it is impossible to measure the value of resistance by the carriers originally existing in the ambipolar inorganic semiconductor. On the contrary, when the work function of the metal electrode to be used is not sufficiently low to be able to implant electrons into the ambipolar inorganic semiconductor and not sufficiently high to be able to implant holes, it is not possible to supply a current into the ambipolar inorganic semiconductor. Therefore, in all cases, the DC resistance value intrinsic to the ambipolar inorganic semiconductor can not be measured.

If the mobility of the ambipolar inorganic semiconductor is found by the time of flight method based on the pulse photoexcitation and the carrier density in the ambipolar inorganic semiconductor is found by a capacitance-voltage measurement method, the specific resistance value can be calculated from these. Further, the specific resistance value can also be calculated by a method of finding AC resistance by use of an electrode which does not allow the carriers to be implanted into the ambipolar inorganic semiconductor.

In terms of the carrier density in the ambipolar inorganic semiconductor, the carrier density is preferably 10¹⁶ /cm³ or less. More preferably, it is 10¹⁴ /cm³ or less. If the carrier density is 10¹⁶ /cm³ or more, the ratio of the carriers implanted from the n-electrode and the p-electrode will be relatively low, and thus the controllability of the light-emitting element is hindered. The carrier density in the ambipolar inorganic semiconductor can be measured by the capacitance resistance measurement method. In addition, in the p-type semiconductor or the n-type semiconductor in the conventional p-n junction type light-emitting diode, sufficient electric conduction can not be obtained unless a large amount of a dopant of 10¹⁷ /cm³ or more is added into an inorganic semiconductor, as described above.

In terms of a dopant ion concentration (this is equal to a dopant concentration, and means a concentration of a dopant which can generate carriers) in the ambipolar inorganic semiconductor, the dopant concentration is preferably 0.1% or more in an atomic ratio. More preferably, it is 1 ppm or less. If the dopant concentration is 0.1% or more, the ratio of the carriers implanted from the n-electrode and the p-electrode will be relatively low, and thus the controllability of the light-emitting element is hindered. The dopant concentration can be measured by X-ray photoelectron spectroscopy, X-ray fluorescence measurement, inductively coupled plasma analysis, secondary ion mass spectrometry, etc.

Furthermore, the dopant concentration in the ambipolar inorganic semiconductor is preferably controlled in such a manner as to focus attention on an ion species which breaks the ambipolarity. As described above, the lower dopant concentration is preferable for the ambipolar inorganic semiconductor, but a semiconductor with a high degree of purity for all species of ions is not easy to manufacture as such, and this is not essential as a characteristic of the semiconductor. That is, the concentration of the dopant of the species which breaks the ambipolarity is preferably set at 10¹⁶ /cm³ or less. The inventors of the present application have found that the species which break the ambipolarity are halogen including F, Cl, Br and I, and Li, N and Cu, and confirmed that a satisfactory ambipolar inorganic semiconductor is obtained by setting the dopant concentration at 10¹⁶ /cm³ or less for these species. Moreover, the inventors have also found that the concentration is preferably 10¹⁶ /cm³ or less for elements of O, H and C in terms of the luminous efficiency.

An intrinsic semiconductor with a high degree of purity is the best for a material used for the ambipolar inorganic semiconductor. As described later, it is possible to use, for the ambipolar inorganic semiconductor, crystalline materials including, in addition to ZnS-based materials, other group II-VI semiconductors, group III-V semiconductors, carbon-based materials, SiC, semiconductor oxides such as CuInO₂, Si₃N₄, and semiconductor nitrides such as AlN.

Here, the group II-VI semiconductor is a semiconductor comprising at least one element selected from the group consisting of Zn, Cd and Hg which are IIB elements on the periodic table and at least one element selected from the group consisting of O, S, Se, Te and Po which are VIA elements, and is, for example, ZnO, ZnS, ZnSe, ZnTe, CdO, CdS, CdSe, CdTe or the like. Further, the group III-V semiconductor here is a semiconductor comprising at least one element selected from the group consisting of B, Al, Ga, In and Tl which are IIIA elements on the periodic table and at least one element selected from the group consisting of N, P, As, Sb and Bi which are VA elements, and is, for example, AIN, AlP, AlAs, GaN, GaP, GaAs, InN, InP, InAs or the like.

Advantages of using the crystalline material for the ambipolar inorganic semiconductor are, for example, that the mobility is high, that nonradiative transition due to a localized level of a band edge is less, and that free excitons stably exist in ZnSe, ZnS, C (diamond) or the like and this contributes to highly efficient light emission.

If the light-emitting layer is a monocrystalline ambipolar inorganic semiconductor, there is no grain boundary in the light-emitting layer, so that this semiconductor is preferable because a moving characteristic of the carriers is excellent and the highly efficient light emission can be achieved.

Furthermore, when the light-emitting layer is a polycrystalline ambipolar inorganic semiconductor, it is not necessary to use the monocrystalline substrate as the substrate, so that it is easily manufactured and preferable in terms of cost. For example, since it can be manufactured on the glass substrate or the plastic substrate, it is possible to realize a large-area device using a large-sized substrate (e.g., 1 m square). Also, when a small-area device is manufactured, the number of processes can be reduced by using the large-area substrate, and it is preferable in terms of cost.

On the other hand, an amorphous semiconductor such as C or Si can also be used for the ambipolar inorganic semiconductor. Advantages of using the amorphous material for the ambipolar inorganic semiconductor are, for example, that a film formation temperature is low, that a degree of freedom is high in composition, and that it has an isotropic physical property. Especially, since the film formation temperature is low, the plastic substrate can be used for the substrate, thereby providing a wider range of substrate selection. A range of choice is also widened in polymeric materials used for the plastic substrate.

Furthermore, when the light-emitting layer is an amorphous ambipolar inorganic semiconductor, there is no grain boundary in the light-emitting layer, so that this semiconductor is preferable because the moving characteristic of the carriers does not deteriorate due to the grain boundary and the luminous efficiency is not reduced.

The electrons and holes implanted into the ambipolar inorganic semiconductor which is the light-emitting layer recombine with each other, and emit light corresponding to the inter-emission-level energy difference. The emission level means a set of a level of the electron and a level of the hole which contributes to the light emission, and its positions are classified into several cases.

A first set of emission levels includes a conduction band edge and a valence band edge. In this case, the inter-emission-level energy difference corresponds to a forbidden bandwidth of the ambipolar inorganic semiconductor. A second set of emission levels includes an exciton level and the valence band edge, or the exciton level and the conduction band edge. A third set of emission levels is a set of a level due to the defects existing in the ambipolar inorganic semiconductor and a level due to the conduction band or the valence band or the defects. In the present invention, existence of the level due to the defects is not preferable, and the ambipolar inorganic semiconductor is preferably crystalline or amorphous which is as complete as possible.

Hereinafter, the ambipolar inorganic semiconductor used as the light-emitting layer will be described for each matter system.

### (1) ZnS-based Semiconductor

A ZnS-based light-emitting layer is a substance including Zn and at least one element selected from the group consisting of S, Se and Te, and specifically includes ZnS, ZnSe, ZnTe, ZnSₓSe(₁₋ₓ) (0<x<1), etc. These substances have high melting points, are stable at room temperature, and do not change their natures even if they are exposed to sunlight, so that they provide high reliability to the light-emitting diode of the present invention.

The ZnS-based light-emitting layer may be amorphous, but in terms of the luminous efficiency, it is preferably crystalline. The crystal structure decides a band structure of the light-emitting layer, decides an emission wavelength and the luminous efficiency, and is therefore an important factor. Crystals of ZnS, ZnSe and ZnTe have a ZnS-type (β-ZnS structure, Zinc Blend structure) or wurtzite-type (α-ZnS structure) crystal structure, and both the crystal structures can be used for the light-emitting layer of the present invention.

### (A) ZnS

ZnS includes the wurtzite-type crystal structure in addition to the ZnS-type crystal structure. The ZnS type is hypothermic phase, and shifts to the wurtzite type at 1.020°C. ZnS has a forbidden bandwidth of 3.7 eV. An energy of 3.7 eV corresponds to 335 nm in light wavelength. Further, ZnS is a direct transition type semiconductor, and this is one of the causes for high luminous efficiency. That is, if recombination emission coefficients of the electrons and holes are compared regarding a direct transition type and a indirect transition type, the recombination emission coefficient of the direct transition type is about four digits higher. The light is emitted by a direct recombination between the electrons and holes existing at the band edge of ZnS or by a recombination of excitons located in the vicinity of the band edge. Therefore, the light-emitting diode of the present invention emits ultraviolet light with a wavelength of about 335 nm.

So far, no p-n junction type light-emitting diode based on ZnS has been realized. The reason is that p-ZnS has not been realized because there is not any technique to implant holes into the valence band of ZnS. Therefore, in a current injection type light emitting device using ZnS, holes have been implanted through a Schottky barrier (MES device) or by tunnel emission (field emission) or from an interface state. Thus, it has been impossible to inject a sufficiently high current at a low voltage suitable for practical applications, and the light-emitting device using ZnS has not been widely prevailed in society.

In the light-emitting diode of the present invention, the light-emitting layer is not doped to generate carriers, and therefore, p-ZnS is not necessary. In the present invention, the sufficiently high current can be passed at the low voltage suitable for practical applications in order to bring the ohmically joined p-electrode and n-electrode into contact with a ZnS layer which is the light-emitting layer and efficiently implant the holes and electrons into the ZnS layer, thereby making it possible to realize a highly practical solid light-emitting element.

### (B) ZnSe

ZnSe is a direct transition type wide gap semiconductor which has the ZnS-type crystal structure and a forbidden bandwidth of 2.8 eV. Characteristics of the semiconductor are superior to those of ZnS and ZnTe in some aspects. The forbidden bandwidth thereof is narrower than that of ZnS. Since the wavelength of light corresponding to an energy of 2.8 eV is 440 nm, it can be used to emit visible light and infrared light having a wavelength longer than 440 nm. Since this semiconductor is a direct transition type semiconductor similar to ZnS, the recombination emission coefficient is high. The light is emitted by the direct recombination between the electrons and holes existing at the band edge of ZnSe or by the recombination of excitons located in the vicinity of the band edge. Therefore, the light-emitting diode of the present invention emits blue light with a wavelength of about 440 nm.

Since ZnSe can be subjected to n-type and p-type doping, a p-n junction can be manufactured, and moreover, the light-emitting devices such as the light-emitting diode and a laser diode are realized. The light-emitting diode by the p-n junction of ZnSe has an excellent light emission characteristic, and has achieved a luminous efficiency of 8 1m/W (Kanji Bando et al., Applied Physics Letters, vol. 71, page 1518, 2002).

However, the ZnSe-based light-emitting device is complicated in structure. Moreover, because of a short device life, it has not been placed into practical use. This is considered to be due to the fact that the defects generated in the ZnSe crystal by a p or n dope or the like proliferate during electric field application and act as the quenching center.

On the other hand, in the light-emitting diode of the present invention, the light-emitting layer is not doped to generate carriers. The ohmically joined p-electrode and n-electrode may be brought into contact with a ZnSe layer which is the light-emitting layer, and the holes and electrons may be implanted into the ZnSe layer. Thus, the electrode material can be widely selected, and a device structure can be simplified. Moreover, since ZnSe which is the light-emitting layer does not contain the p-type or n-type dopant, the crystallinity does not decrease due to the dopant, defect density is low, and the defect density is not easily increased by the electric field application, thereby enabling a long device life.

### (C) ZnTe

ZnTe is a direct transition type wide gap semiconductor which has the ZnS-type crystal structure or the wurtzite-type crystal structure and has a forbidden bandwidth of 2.3 eV. Characteristics of this semiconductor are superior to those of ZnS and ZnTe in some aspects. The forbidden bandwidth is narrower than that of ZnSe. The wavelength of light corresponding to an energy of 2.3 eV is 520 nm. Since this semiconductor is a direct transition type semiconductor similar to ZnS, the recombination emission coefficient is high. The light is emitted by the direct recombination between the electrons and holes existing at the band edge of ZnTe. Therefore, the light-emitting diode of the present invention emits green light with a wavelength of about 520 nm.

In the light-emitting diode of the present invention, the light-emitting layer is not doped to generate carriers. The ohmically joined p-electrode and n-electrode may be brought into contact with a ZnSe layer which is the light-emitting layer, and both the carriers may be implanted into the ZnTe layer, thereby allowing the light-emitting element to be realized.

### (D) Solid Solution

Since ZnS, ZnSe and ZnTe have the same crystal structure and dissolve each other in the whole area, they can create a solid solution such as ZnSeₓSe₍₁₋ₓ₎ or ZnS_{y}Te_{(1-y)}, and it can be used for the light-emitting layer of the present invention. As the substitution is changed in order of S → Se → Te, a band gap becomes narrower, so that light with a longer wavelength can be emitted.

Regarding the energy difference at the band edge, 3.7 eV corresponds to a wavelength of 335 nm for ZnS, 2.8 eV corresponds to a wavelength of 440 nm for ZnSe, and 2.4 eV corresponds to a wavelength of 520 nm for ZnTe. Cd, Mg, Ca, Sr, Ba or the like can be substituted for part of Zn. For example, ZnₓCd₍₁₋ₓ₎S, ZnxMg₍₁₋ₓ₎Se, ZnₓCa₍₁₋ₓ₎Te, ZnₓCd₍₁₋ₓ₎Se_{y}S ₍₁₋ₓ₎ or the like can be used for the light-emitting layer. In this case, Zn to be substituted for is up to 10% of Zn. Since the band gap can be widened or narrowed by substituting the part of Zn, the emission wavelength can be adjusted.

### (2) GaN-based Semiconductor

In the present specification, a GaN-based semiconductor is a substance including at least one element selected from the group consisting of Ca, In and Al, and N, and specifically includes GaN, InN, AlN, GaₓIn₍₁₋ₓ₎N, GaₓAl ₍₁₋ₓ)N, etc. As the substitution is changed in order of In → Ga → Al, the position of the conduction band edge can be controlled and the forbidden bandwidth can be widened, so that light with a shorter wavelength can be emitted. Since the GaN-based semiconductor is a direct semiconductor, probability of emission recombination between the electrons located in the conduction band and the holes located in the valence band is high, and the highly efficient light emission can be achieved. The GaN-based semiconductor is preferably highly crystalline.

### (3) SiC-based Semiconductor

In the present invention, the SiC-based semiconductor is a substance containing Si and C. A large number of polymorphisms exist in an SiC crystal, and a physical property value is different for each crystal structure. The forbidden bandwidth is 2.39 eV for 3C-SiC, 3.02 eV for 6H-SiC, and 3.27 eV for 4H-SiC. Since the SiC-based semiconductor is an indirect semiconductor, the probability of the emission recombination between the electrons located in the conduction band and the holes located in the valence band is low, and it is preferable to introduce a luminescence center described later to achieve the highly efficient light emission. The SiC-based semiconductor is preferably highly crystalline.

### (4) Diamond-based Semiconductor

In the present invention, the diamond-based semiconductor is a substance including, as the main component, carbon mainly forming sp³ hybrid orbitals. As it forms the sp³ hybrid orbital, semiconductive properties can be obtained. It is possible to check whether the sp³ hybrid orbital is formed and to check its component ratio by NMR, ultraviolet Raman spectroscopy, electron beam energy loss spectroscopic analysis or the like. 80 at% or more of carbon atoms preferably form the sp³ hybrid orbital. More preferably, 90 at% or more of the carbon atoms among all composition atoms form the sp³ hybrid orbital.

The overall structure may be crystalline or amorphous. It may be amorphism containing a crystalline substance therein. The crystalline substance in these cases is preferably diamond having a polycrystalline structure. That is, either when the overall structure is crystalline or when it is the crystalline substance in the amorphism, the contained crystalline substance preferably has a diamond-type crystal structure. Among semiconductors having diamond-type crystal, monocrystalline diamond is preferable. Materials in which the overall structure is crystalline include polycrystalline diamond and monocrystalline diamond.

Amorphous substances include amorphous carbon (a-C), hydrogenated amorphous carbon (a-C:H), amorphous carbon nitride (a-Cₓ N_{y}), hydrogenated amorphous carbon nitride (a-CₓN_{y}:H), nitrogenized amorphous carbon (a-C:N), halogenated amorphous carbon (a-C:F, a-C:Cl, etc.).

The mobility of the electrons and holes is high in a diamond crystal. Since the diamond crystal is an indirect semiconductor, the probability of the emission recombination between the electrons located in the conduction band and the holes located in the valence band is low. However, a metastable state of the electrons and holes (free excitons, excitons) can be formed, and the efficiency of light emission by the recombination from the free excitons is very high, so that light emission can be efficiently performed. The free excitons are the electrons which are in a state bound in the holes and in a metastable intermediate state. In the case of the present invention, the electrons mainly implanted from the n-electrode are bound in the holes mainly implanted from the p-electrode, thereby forming the free excitons in the intermediate state. The light emission from the free excitons corresponds to a photon energy of about 5.2 eV, and is about 238 nm in wavelength.

In the case of amorphous carbon, the probability of the emission recombination between the electrons located in the conduction band and the holes located in the valence band is high, and the highly efficient light emission can therefore be achieved. The emission wavelength of amorphous carbon is about 400 to 600 nm. Specifically, in typical tetrahedral amorphous carbon (ta-C), the inter-recombination-level energy difference is about 2.5 eV, and

this corresponds to a wavelength of 500 nm.

### (5) Si-based Semiconductor

An Si-based semiconductor in the present invention is a semiconductor containing Si as the main component. The semiconductors containing Si as the main component includes an Si crystal and an amorphous crystal.

The Si crystal has a diamond structure, and has a forbidden bandwidth of 1.1 eV. Since the Si crystal is an indirect semiconductor, the probability of the emission recombination between the electrons located in the conduction band and the holes located in the valence band is low. The Si crystal is preferably highly crystalline.

### . n-electrode and p-electrode

The n-electrode and the p-electrode have functions to implant the electrons and holes, respectively, into the light-emitting layer by applying a voltage across the electrodes. As described above, both the n-electrode and the p-electrode may be a metal or a semiconductor or a combination of the metal and the semiconductor which allows the electrons or holes to be implanted into the light-emitting layer, and a substance is selected so that a combination can be formed which does not create a barrier between the substance and the ambipolar inorganic semiconductor forming the light-emitting layer. The reason is that since the carriers do not originally exist in the ambipolar inorganic semiconductor of the present invention, it is impossible to implant the electrons or holes into the ambipolar inorganic semiconductor without realizing a non-barrier junction between the electrode and the ambipolar inorganic semiconductor.

In the case of the n-electrode, if the work function of the n-electrode is lower than conduction band edge energy of the ambipolar inorganic semiconductor, a combination is formed which does not create the barrier between them. In the case of the p-electrode, if the work function of the p-electrode is higher than the conduction band edge energy of the ambipolar inorganic semiconductor, a combination is formed which does not create the barrier between them. When a junction with the ambipolar inorganic semiconductor is created, a substance must be selected and a process must be designed so that an unintended barrier is not formed, for example, by inducing a chemical reaction.

A substance which allows the non-barrier junction with the ambipolar inorganic semiconductor may have a chemical composition and crystal structure different from those of the ambipolar inorganic semiconductor. For example, it has been reported that when ZnSe is selected for the ambipolar inorganic semiconductor, the conduction band edge energy of ZnSe is 3.8 eV (compiled by Bhargava, Properties of Wide Bandgap Group II-VI Semiconductors, page 38, Inspec Corporation, 1997). On the other hand, it has been described that the work function of Mg is 3.46 eV (Semiconductor Device Engineering, written by Yoshihiro Hamakawa, page 31, Ohm Corporation). Thus, if the unintended barrier is not formed between them, for example, by a chemical reaction, a combination of ZnSe and Mg enables the non-barrier junction.

The substances which allow the non-barrier junction with the ambipolar inorganic semiconductor are not limited to metals. For example, Morita et al. have discovered a new Cu-Al-Se-based compound, and have created a junction with ZnSe to examine a current/voltage characteristic thereof (Japanese Journal of Applied Physics, vol. 30, page 3802, 1991). Such a substance may be found to manufacture the junction with the ambipolar inorganic semiconductor, and the electrons or holes may be implanted therein.

The n-electrode and the p-electrode of the present invention include a combination of a metal layer and a semiconductor layer. For example, the semiconductor layer is formed between the metal layer which does not allow the non-barrier junction with the ambipolar inorganic semiconductor, and the ambipolar inorganic semiconductor so that the semiconductor layer serves as the n-electrode and the p-electrode, thereby enabling carriers to be implanted.

For example, when a ZnSe semiconductor is used as the ambipolar inorganic semiconductor, p-ZnSe is first formed in contact with ZnSe, and a metal such as Pt is further joined to the p-ZnSe layer, thereby enabling holes to be implanted into the ZnSe semiconductor. In this case, a laminated structure portion of p-ZnSe/Pt can be referred to as the p-electrode. The same applies to the n-electrode, and, for example, if a laminated structure of n-ZnSe/Al is produced, electrons can be implanted into ZnSe semiconductor.

P-ZnSe is realized by introducing Li or N as an acceptor into ZnSe. Especially, N is effective as the acceptor to generate holes with a high concentration, and a hole density of about 1 × 10¹⁸ /cm³ can be reproducibly obtained (S.W. Lim et al., Applied Physics Letters, vol. 65(1994), page 2437). Further, n-ZnSe is realized by introducing Al and Cl as donors into ZnSe.

The light-emitting diode of the present invention includes a light-emitting diode in which a material of a portion contacting the light-emitting layer in at least one of the n-type electrode and p-type electrode is formed by use of a material substantially different from the material of the light-emitting layer. Here, the "substantially different material" naturally includes a material whose composition, crystal structure and the like are different, but does not include, for example, a material in which a dopant is dispersed into the ambipolar inorganic semiconductor forming the light-emitting layer.

It is to be noted that the light-emitting diode of the present invention is totally different from a conventional so-called pin structure in respect of function and structure. The conventional pin-type diode is widely used as a photodiode for photon detection. In light emission of the pin-type photodiode, the holes transported from the p-type semiconductor layer and the electrons transported from the n-type semiconductor layer are confined to an i-layer located at the midpoint between the p-type semiconductor layer and the n-type semiconductor layer to obtain high luminous efficiency. Thus, in the pin-type diode, the i-layer is generally formed at a thickness of several nm to several ten nm to spatially confine both the carriers to the i-layer. Moreover, in order to confine both the carriers to the i-layer in terms of energy, the forbidden bandwidth of the i-layer is designed to be narrower than the forbidden bandwidths of the p-layer and the n-layer. Thus, the conventional pin-type diode has an upper limit in the carrier concentration in the p-type semiconductor layer and the n-type semiconductor layer because a spatial thickness (film thickness) of the i-layer is small. That is, if the carrier concentration in the p-type semiconductor layer and the n-type semiconductor layer is high (e.g., to a degree that metallic conduction is shown), a potential difference applied to both the layers concentrates on the i-layer, and electric field intensity in the i-layer increases (e.g., 1 MV/cm), so that dielectric breakdown is easily caused and this diode will not function as a diode. Therefore, it is necessary to restrain the carrier concentration in the p-type semiconductor layer and the n-type semiconductor layer, and assign the applied potential difference not only to the i-layer but also to the p-type semiconductor layer and the n-type semiconductor layer.

On the other hand, in a case of a laminated structure of "the p-electrode (this may include the p-type semiconductor)/the light-emitting layer/the n-electrode (this may include the n-type semiconductor) in the light-emitting diode of the present invention, a distance between the p-electrode and the n-electrode corresponds to a film thickness of the light-emitting layer made of the ambipolar inorganic semiconductor material, but the light-emitting layer of the present invention can be designed to be thick (e.g., 100 nm or more). Thus, even when the carrier concentration from p-electrode and the n-electrode is high (e.g., to a degree that the metallic conduction is shown), the applied potential difference can be concentrated on the light-emitting layer, and the materials of both the electrodes can be selected from various materials.

Furthermore, in a structure of the conventional pin-type diode, a monocrystalline substrate is used for the substrate on which the p-type (or n-type) semiconductor layer, the i-layer, the n-type (or p-type) semiconductor layer have epitaxially grown in a sequential manner. Thus, the substrate is limited to the monocrystalline substrate, and the p-type semiconductor layer, the i-layer and the n-type semiconductor layer need to be manufactured by adding a p-dopant or n-dopant to the same semiconductor material.

On the contrary, in the light-emitting diode of the present invention, the crystal structure and material of the light-emitting layer made of the ambipolar inorganic semiconductor are not limited, and various materials can be selected. For example, when the light-emitting layer is monocrystalline, the light-emitting layer only needs to be monocrystallized, and the materials of the p-electrode and the n-electrode do not need to be the same material as that of the light-emitting layer. When the light-emitting layer is formed on the n-electrode, it is only necessary for a monocrystalline light-emitting layer to be electrically connected onto the n-electrode in a satisfactory manner. For example, in a case of an oxide monocrystal, it is known that consistency of a lattice constant is not an essential condition for the epitaxial growth. Therefore, after epitaxially growing a Ga-doped ZnO monocrystalline layer as the n-electrode on a sapphire monocrystalline substrate, a ZnSe layer is epitaxially grown as the light-emitting layer, and a CuFeS₂ (a coefficient does not indicate a strict composition ratio. The same holds true for the following.) layer having a chalcopyrite structure is further stacked as the p-electrode, thereby making it possible to manufacture the light-emitting diode of the present invention.
Moreover, as described above, in the light-emitting diode of the present invention, the light-emitting layer may be polycrystalline or amorphous, a polycrystalline substrate, the glass substrate or the like can therefore be used for the substrate.

### [Examples]

Hereinafter, specific examples will be shown, and the embodiment will be described in further detail.

### (Example 1)

ZnSe was selected as an ambipolar inorganic semiconductor forming a light-emitting layer. A GaAs (100) monocrystalline wafer (carrier density: 1 × 10¹⁸ /cm³) doped for an n type was immersed in a so-called piranha solution (mixed solution of H₂, O₂, H₂OS₄) to remove an oxide layer on a surface thereof. This was quickly introduced as a substrate for film formation into a molecular beam epitaxy (MBE) vacuum device for film formation (manufactured by Eikoh Engineering, ultimate vacuum: 5 × 10⁻¹⁰ Torr), and fixed thereto. Then, a temperature of the substrate was raised to 500°C, and it was confirmed by looking a reflection high energy electron diffraction image (RHEED) that a clean and flat surface was exposed. Further, the substrate temperature was dropped to 400°C, and a molecular beam of each component was emitted from a Zn cell and an Se cell and applied to the GaAs (100) substrate, thereby forming a ZnSe thin film at 2 µmt.

Next, carrier mobility in the thin film was measured by a flight time measurement device. A block diagram of the measurement device is shown in FIG. 6. After gold thin films were formed on a surface of the thin film and on a rear surface of the substrate to produce a blocking electrode 51, a thin film sample was fixed onto an XYZθ-stage 52. A rectangular voltage generated from a pulse generator 53 was amplified by a power amplifier 54 to apply a voltage of 200 V at the maximum across both electrodes of the thin film sample. Moreover, both the electrodes were connected to an oscilloscope 55 to measure a transient response current flowing across both the electrodes. On the other hand, a trigger from the pulse generator 53 was input to a YAG laser oscillator 57, and laser light was generated synchronously with the generation of the rectangular voltage, converted to a laser wavelength of 266 nm by a nonlinear optical device, and applied to a surface of the thin film sample. A half-value width of the laser light was 10 nsec. It was found from transient response curves of the current that mobility of electrons was 70 cm²/Vs and that mobility of holes was 10 cm²/Vs.

Furthermore, an impurity concentration in the thin film sample was measured by a secondary ion mass spectroscope. No impurity ions whose density exceeds 10¹⁹ /cm³ were detected except for Zn and Se, and it was determined from this that the impurity ion concentration was 0.1% or less. Further, an electrode was formed on the surface of the thin film sample, and a capacitance-voltage characteristic was measured by a Gain-Phase Analyzer 4194A manufactured by Hewlett-Packard Corporation. Thereby, it was determined that the carrier density in the thin film sample was 10¹⁴ /cm³ or less. It was found that a specific resistance value was 2 × 10⁵ Ωcm or more from an average value of the electron mobility and the hole mobility of 40 cm²/Vs and from a carrier density of 1 × 10¹⁴ /cm³ or less. A specific resistance value obtained by an alternating current method was 1 × 10⁹ Ωcm.

### (Example 2)

As in Example 1, an n-GaAs (100) monocrystalline wafer was immersed in a piranha solution, and introduced and fixed in an MBE vacuum device for film formation. A temperature was raised to 500°C, and it was confirmed by looking a reflection high energy electron diffraction image (RHEED) that a clean and flat surface was exposed. Then, the substrate temperature was dropped to 400°C, and a molecular beam of each component was emitted from a Zn cell, an Se cell and an Al cell, and applied to the n-GaAs (100) substrate, thereby forming a film of an n-type ZnSe doped with Al at 2 µmt. In other words, an n-electrode having an n-GaAs/n-ZnSe structure was formed. Next, a ZnSe layer is stacked on this layer at 200 nmt to produce a light-emitting layer. Further, a molecular beam of an N atom in a radical state was applied onto the substrate together with the molecular beams of Zn and Se by use of an ion source manufactured by Oxford Applied Research Corporation, and a film of p-ZnSe doped with N was formed at 2 µmt. At this time, it was confirmed by the RHEED that a Zn-terminated ZnSe crystal film was formed. After a film of Pd was formed at 50 nmt on an uppermost layer by sputtering, a film of Au was formed at 200 nmt. In other words, a p-electrode having an p-ZnSe/Pd/Au structure was formed. This corresponds to a light-emitting diode having a structure shown in FIG. 1.

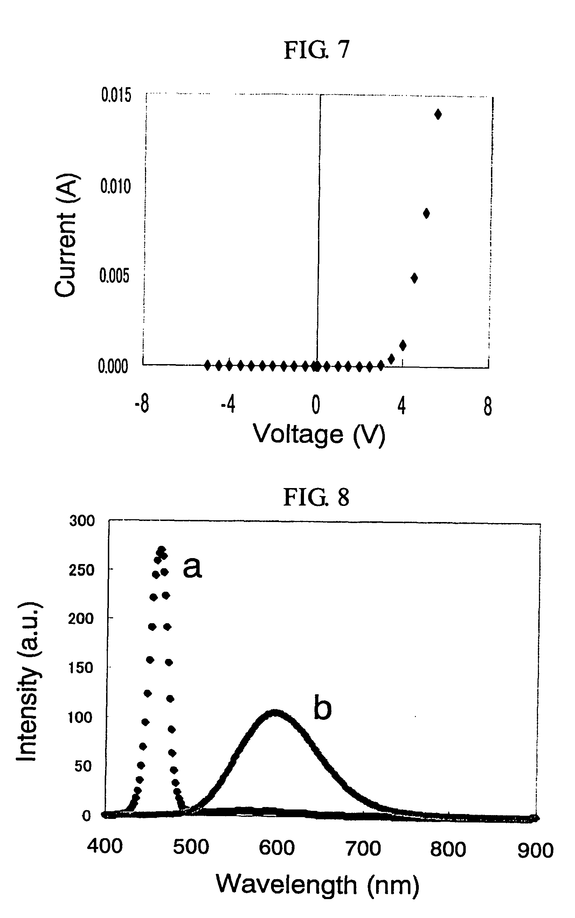

FIG. 7 shows a voltage/current curve when a voltage is applied across an n-GaAs substrate and an Au electrode of the light-emitting diode. A satisfactory nonlinear curve was obtained. A rising voltage was in the vicinity of 3 V, and this corresponds to a forbidden bandwidth of ZnSe which is an ambipolar inorganic semiconductor material. Further, FIG. 8 shows emission spectra obtained when a voltage of 5V is applied. a indicates an emission spectrum according to the light-emitting diode of the present example, and a spectrum having a narrow half-value width was obtained at a wavelength of 460 nm. A wavelength of 460 nm is 2.7 eV when converted into light energy, which coincides with the forbidden bandwidth of ZnSe which is the ambipolar inorganic semiconductor material. A light-emitting portion is considered to be between p-electrode/light-emitting layer interface and a light-emitting layer/n-electrode interface.

Furthermore, in a light-emitting diode manufactured in the same manner as the light-emitting diode of the present example except that a thickness of the light-emitting layer ZnSe was changed to 500 nm, light emission was confirmed which was similar to light emission when the thickness of the light-emitting layer ZnSe was 200 nm. Moreover, the increased thickness of the light-emitting layer increased insulating resistance properties, and it was confirmed that a current during operation was stabilized.

In addition, in the present example, a p-n junction type light-emitting diode can be manufactured by not forming the ZnSe light-emitting layer. b in FIG. 8 indicates an emission spectrum according to the p-n junction type light-emitting diode thus manufactured. Light is emitted which has a large half-value width and a wavelength of about 600 nm. This is considered to be light emission derived from an N dopant existing in p-ZnSe or light emission derived from an A1 dopant existing in n-ZnSe.

An S evaporation source was used instead of an Se evaporation source. An n-GaP monocrystalline substrate (a lattice constant of a ZnS light-emitting layer was considered) was used instead of the n-GaAs substrate. A CuFeS₂ layer having a chalcopyrite structure was used instead of the N-doped p-ZnSe layer. A ZnS light-emitting layer was formed on a GaP monocrystalline substrate. Thus, the light-emitting diode shown in FIG. 1 was manufactured. When a voltage of 10 V was applied across the p-electrode and the n-electrode of the light-emitting diode, ultraviolet light having a wavelength of 335 nm was emitted.

Furthermore, an I-doped n-ZnS layer, a ZnS inorganic light-emitting layer (200 nm), an N-doped p-ZnS layer, a Pd layer and an Au layer were sequentially formed on an n-GaP monocrystalline substrate, and thus the light-emitting diode shown in FIG. 1 was manufactured, thereby obtaining a similar light emission characteristic.

Moreover, an I-doped n-ZnS layer, a ZnS inorganic light-emitting layer (200 nm), a CuFeS₂ layer having a chalcopyrite structure, a Pd layer and an Au layer were sequentially formed on an n-GaP monocrystalline substrate, and thus the light-emitting diode shown in FIG. 1 was manufactured, thereby obtaining a similar light emission characteristic.

A Te evaporation source was used instead of the Se evaporation source. The n-GaSb monocrystalline substrate (a lattice constant of a ZnTe light-emitting layer was considered) was used instead of the n-GaAs substrate. The CuFeS₂ layer having the chalcopyrite structure was used instead of the N-doped p-ZnSe layer. A ZnTe light-emitting layer was formed on a n-GaSb monocrystalline substrate. Thus, the light-emitting diode shown in FIG. 1 was manufactured. When a voltage of 10 V was applied across the p-electrode and the n-electrode of the light-emitting diode, green light having a wavelength of 520 nm was emitted.

Furthermore, a Cl-doped n-ZnTe layer, a ZnTe inorganic light-emitting layer (200 nm), an N-doped p-ZnTe layer, a Pd layer and an Au layer were sequentially formed on the n-GaSb monocrystalline substrate, and thus the light-emitting diode shown in FIG. 1 was manufactured, thereby obtaining a similar light emission characteristic.

Moreover, an C1-doped n-ZnTe layer, a ZnTe inorganic light-emitting layer (200 nm), a CuFeS₂ layer having a chalcopyrite structure, a Pd layer and an Au layer were sequentially formed on the n-GaSb monocrystalline substrate, and thus the light-emitting diode shown in FIG. 1 was manufactured, thereby obtaining a similar light emission characteristic.

In addition, each of the light-emitting layers in the light-emitting diode of the present example was formed by epitaxial growth on the n-electrode.

### (Example 3)

In Example 2, a stacking order was changed in the following manner. Example 3 will be described with FIG. 10. A p-ZnSe film 136 doped with N was formed at 2 µm on a non-doped p-GaAs (100) substrate 131. Next, part of the p-ZnSe substrate 136 was covered with a mask, and a ZnSe layer 135 was stacked at 200 nm on the remainder, thereby producing a light-emitting layer. Moreover, after an Mg film 132 was deposited on the light-emitting layer, the Mg film 132 was covered with an Au film 134, and an n-electrode 133 was thus produced as an Mg/Au laminated film. Next, the mask covering a surface of p-ZnSe was removed, and a Pd film 138 was vapor-deposited on the surface, and then an Au film 139 was further deposited thereon, thereby creating a p-ZnSe/Pd/Au structure as a p-electrode 137. When a voltage of 10 V was applied across the electrodes, an emission spectrum similar to that of a in FIG. 8 was obtained.

In addition, when a Cl-doped n-ZnSe/Mg/Au structure was employed as the n-electrode, a similar light emission characteristic was obtained. When a CuFeSe₂/Pd/Au structure was employed as the p-electrode, a similar light emission characteristic was obtained.

### (Example 4)

A GaN thin film (500 nm) was formed as a light-emitting layer on a sapphire substrate by a CVD method, and thus the light-emitting diode shown in FIG. 1 was manufactured. Here, p-GaN:Mg (this means Mg-doped p-type GaN. The same holds true for the following.) was used for a p-electrode material, while n-GaN:Si was used for an n-electrode material. When a voltage of 10 V was applied across the p-electrode and the n-electrode of the light-emitting diode, purple light having a wavelength of about 400 nm was emitted.

When InN (500 nm) was formed as the light-emitting layer by the CVD method, and when AlN (500 nm) was formed as the light-emitting layer by the CVD method, similar satisfactory current injection light emission was obtained.

Moreover, it was confirmed that the satisfactory current injection light emission was also obtained when CuFeS₂ was used as the p-electrode instead of p-GaN:Mg.

In addition, each of the light-emitting layers in the light-emitting diode of the present example was formed by heteroepitaxial growth on the n-electrode.

### (Example 5)

A 3C-SiC monocrystalline thin film (500 nm) was formed on an Si substrate by an LP-CVD method, and thus the light-emitting diode shown in FIG. 1 was manufactured. Here, a p-electrode and an n-electrode were formed in such a manner that a p-3C-SiC layer and an n-3C-SiC layer were formed by implanting N or P into the 3C-SiC monocrystalline thin film by an ion implantation method, and that a metal electrode was placed into contact with both the layers. When a voltage of 10 V was applied across the p-electrode and the n-electrode of the light-emitting diode, green light having a wavelength of about 520 nm was emitted.

Light-emitting layers in the light-emitting diode of the present example were formed by epitaxial growth on the n-electrode.

Moreover, it was confirmed that satisfactory current injection light emission was also obtained when CuFeS₂ was used as the p-electrode instead of p-3C-SiC.

### (Example 6)

As a substrate, a plate-shaped Ib-type diamond monocrystal synthesized at high pressure and high temperature was prepared whose surface was a square with a side of 2 mm and whose thickness was 0.2 mm. A surface of the diamond substrate was formed by mechanical flat-surface polishing of a {100} facet of the diamond crystal. A misorientation angle was 0.5°. This crystal diamond substrate was ultrasonically cleaned using isopropanol and acetone, and then ultrasonic waves were applied thereto simultaneously with immersion into chromic acid, and the substrate is further subjected to a so-called RCA cleaning process, thereby removing adsorbed substances.

Next, an undoped homoepitaxial diamond film was formed on the diamond substrate using a microwave plasma chemical vapor growth (hereinafter, MW-PCVD) method. The cleaned diamond substrate was attached to a substrate holder with a heater grounded in a film formation chamber of an MW-PCVD device, and ultra-high vacuum air discharge (background pressure: 5 × 10⁻⁶ Pa) was carried out. The substrate holder was heated to a constant temperature by resistance-heating type heater, and a microwave whose frequency was 2.5 GHz was introduced into the film formation chamber under a condition in which the diamond substrate mounted on the substrate holder was thermally equilibrated with a set temperature of the substrate heater, and thus material gas plasma was generated, thereby forming the homoepitaxial undoped diamond crystal film on the substrate.

A mixed gas in which high-purity methane (CH₄) was diluted with high-purity hydrogen (H₂) was used for the material gas. A concentration of methane was set at 3 molecular percent (sample #1), 1 molecular percent (sample #2), and 0.2 molecular percent (sample #3). A total flow volume of the material gas was set at 100 sccm. A pressure of the material gas in the film formation chamber was set at 30 Torr. Applied microwave electric power was set at 1 kW. A temperature of the substrate was set at 900°C. In a formed diamond crystal film, the {100} surface was used as its growing surface, and a film thickness was 10 µm.

A p-diamond contact layer was formed as part of a p-electrode on the substrate. An undoped diamond layer which was a light-emitting layer was stacked on the p-diamond contact layer. Further, a n-diamond contact layer was formed as part of an n-electrode. Moreover, a metal electrode was formed in contact with both the contact layers. Here, in order to bring the p-contact layer into contact with the metal electrode, there is provided a structure in which part of a surface of the p-contact layer was masked so as to expose the p-contact layer when the light-emitting layer and the n-contact layer are stacked. That is, a light-emitting diode of the present example has a structure shown in FIG. 11, which has, on a substrate 161, a p-electrode (167) composed of a p-diamond contact layer 166 and a metal 168, an undoped diamond layer 165 as the light-emitting layer, and a p-electrode (163) composed of an n-diamond contact layer 162 and a metal 164.

Finally, a conducting wire and a power source were connected to the n-electrode and the p-electrode, respectively, and a voltage was applied. A potential of the n-electrode was set at a reference potential, that is, 0 V, and a potential of the p-electrode was set at a positive value. When a voltage of 50 V was applied, light of 5.2 eV (wavelength: about 238 nm) was emitted. In addition, the light-emitting layers in the light-emitting diode of the present example were formed by epitaxial growth on the p-electrode.

Furthermore, in a modification of the present example, a structure may be provided in which CuFeS₂ is formed as the p-electrode on the light-emitting layer.
That is, when an n-diamond contact layer was formed on a diamond monocrystal substrate, and a diamond layer which is a light-emitting layer and a CuFeS₂ layer as a p-electrode were formed on the n-diamond contact layer, similar light emission was confirmed.

### (Example 7)

A substrate in which an ITO film was formed on a glass substrate (manufactured by Corning Corporation, stock number: 7059) is introduced and fixed in an MBE vacuum device for film formation, and a temperature thereof was raised to 300°C. A molecular beam of each component was emitted from a Zn cell, an Se cell and a C1 cell, and an n-type ZnSe layer including a C1 ion of 1 × 10¹⁹ /cm³ was formed at 1 µm.

Subsequently, the C1 cell was closed, and the molecular beam of each component was emitted from the Zn cell and the Se cell, and then a non-doped ZnSe layer was deposited at 500 mn to form a light-emitting layer.

Next, power raw materials of Cu, Fe and S were weighed and mixed at 0.245:0.245:0.51 (mol ratio) to result in a total amount of 2.0 g, and vacuum-sealed at about 10⁻³ Torr in a quartz glass pipe, and are then subjected to a heat treatment at 450°C for 10 hours and at 975°C for 24 hours. A temperature rise rate and a temperature fall rate were both set at 2°C/minute. An obtained material was press-molded into a pellet having a diameter of 12 mm and a thickness of 1.5 mm by a hydraulic press (pressure: 500 kgf/cm²).

Using this press-molded pellet as a raw material, press vapor deposition film formation was carried out at a substrate temperature of 150°C on the light-emitting layer, and a CuFeS₂ layer composed of CU_{0.246}, Fe_{0.242} and S_{0.512} was formed. This CuFeS₂ layer had a chalcopyrite structure. Then, an Au layer was deposited at 300 nm on an uppermost layer.

That is, n-ZnSe/ITO as an n-electrode and CuFeS₂/Au as a p-electrode were formed.

Subsequently, a negative pole of a power source was connected to the ITO film of the n-electrode, and a positive pole was connected to an Au film of the p-electrode, and then a DC voltage of 5 V was applied, thereby obtaining light emission. A luminescent spectrum had a narrow peak at 480 nm and a wide peak at 600 nm.

### (Example 8)

In Example 7, an ITO film was employed instead of an Au film in a p-electrode, and a see-through type diode was manufactured. As a result, light emission characteristic equivalent to that of a light-emitting diode in Example 7 was obtained.

### (Example 9)

In Example 7, a Cu_{0.3}Fe_{0.2}Se_{0.5} layer was formed instead of CuFeS₂ in a p-electrode, and a light-emitting diode was manufactured. As a result, the light-emitting diode of the present example obtained an emission intensity about ten times as high as that obtained by a light-emitting diode in Example 7 under the same condition.

### (Example 10)

A transparent film of Ga-doped ZnO was formed on a glass substrate (manufactured by Corning Corporation, #7059) by sputtering. As in Example 7, this substrate was placed in an MBE device, and there were sequentially stacked a C1-doped ZnSe film at 1 µm, a non-doped ZnSe film at 500 nm, a CuFeSe₂ layer at 200 nm, and an Au film at 300 nm for an uppermost layer, thereby manufacturing a diode. That is, an n-ZnSe/Ga-doped ZnO as an n-electrode and CuFeSe₂/Au as a p-electrode were formed. As a result, light emission in a visible range was obtained under the same condition as that in Example 7.

### (Example 11)

The present example corresponds to a structure of a light-emitting diode shown in FIG. 9. A non-doped ZnSe film was deposited at 1 µm on a glass substrate (manufactured by Corning Corporation, #7059) of 20 mm square by an MBE device as in Example 7. On this film, a Cl-doped ZnSe film having a size of 1 mm × 0.5 mm was stacked at 300 nm using a metal mask. Subsequently, a CuFeSe₂ film having a size of 1 mm × 0.5 mm was stacked at a thickness of 300 µm on the non-doped ZnSe film with a distance of 0.3 mm from the C1-doped ZnSe film so as to form a shape of a Roman figure II. Further, an Au film was stacked at 300 nm on the formed Cl-doped ZnSe film and CuFeSe₂ film, thereby manufacturing a diode. That is, an n-ZnSe/Au as an n-electrode and CuFeSe₂/Au as a p-electrode were formed.

Subsequently, a negative pole of a power source was connected to the Au film of the n-electrode, and a positive pole was connected to the Au film of the p-electrode, and then a DC voltage of 5 V was applied, thereby emitting visible light.

## Claims

1. A light-emitting diode **characterized by** comprising:
an electron implanting electrode, that is, an n-electrode;
a hole implanting electrode, that is, a p-electrode; and
an inorganic light-emitting layer which is disposed between the n-electrode and the p-electrode so as to contact these electrodes and which is formed of an ambipolar inorganic semiconductor material.

2. The light-emitting diode according to claim 1, **characterized in that**
in the ambipolar inorganic semiconductor material, a ratio of mobility between electrons and holes is in a range of 1/100 to 100.

3. The light-emitting diode according to claim 1, **characterized in that**
in the ambipolar inorganic semiconductor material, each mobility of the holes and the electrons at room temperature is 10⁻¹ cm²/Vs or more.

4. The light-emitting diode according to claim 1, **characterized in that**
the ambipolar inorganic semiconductor material has a dopant concentration of 0.1% or less.

5. The light-emitting diode according to claim 1, **characterized in that**
a thickness of the inorganic light-emitting layer is 10 nm or more and 10 µm or less.

6. The light-emitting diode according to any one of claims 1 to 5, **characterized in that**
the ambipolar inorganic semiconductor material has a group II-VI compound, or Zn and at least one element selected from the group consisting of S, Se and Te.

7. The light-emitting diode according to any one of claims 1 to 5, **characterized in that**
the ambipolar inorganic semiconductor material has a group III-V compound, or N and at least one element selected from the group consisting of Al, Ga and In.

8. The light-emitting diode according to any one of claims 1 to 5, **characterized in that**
the ambipolar inorganic semiconductor material includes, as the main component, carbon forming sp³ hybrid orbitals.

9. The light-emitting diode according to any one of claims 1 to 8, **characterized in that**
the n-type electrode includes a layer formed by use of an n-type inorganic semiconductor material in which an n-type dopant is diffused into the ambipolar inorganic semiconductor material.

10. The light-emitting diode according to any one of claims 1 to 8, **characterized in that**
the p-type electrode includes a layer formed by use of a p-type inorganic semiconductor material in which a p-type dopant is diffused into the ambipolar inorganic semiconductor material.

11. The light-emitting diode according to any one of claims 1 to 8, **characterized in that**
the n-type electrode includes a layer formed by use of an n-type inorganic semiconductor material in which an n-type dopant is diffused into the ambipolar inorganic semiconductor material, and the p-type electrode includes a layer formed by use of a p-type inorganic semiconductor material in which a p-type dopant is diffused into the ambipolar inorganic semiconductor material.

12. The light-emitting diode according to any one of claims 1 to 8, **characterized in that**
a material of a portion contacting the light-emitting layer in at least one of the n-type electrode and the p-type electrode is formed by use of a material substantially different from the material of the light-emitting layer.

13. The light-emitting diode according to any one of claims 1 to 12, **characterized in that**
an ambipolar inorganic semiconductor material is formed on a crystalline substrate or a glass substrate, and the n-electrode and the p-electrode are formed on the ambipolar inorganic semiconductor material so as not to contact each other.

14. The light-emitting diode according to any one of claims 1 to 12, **characterized in that**
the n-electrode or the p-electrode is formed on a crystalline substrate or a glass substrate, and an ambipolar inorganic semiconductor material is stacked thereon, and the p-electrode or the n-electrode is stacked thereon.

## Amended claims

### Amended claims under Art. 19.1 PCT

**1.** A light-emitting diode **characterized by** comprising:
an electron implanting electrode, that is, an n-electrode;
a hole implanting electrode, that is, a p-electrode; and
an inorganic light-emitting layer which is disposed between the n-electrode and the p-electrode so as to contact these electrodes in a non-barrier junction manner and which is formed of an ambipolar inorganic semiconductor material,
wherein the ambipolar inorganic semiconductor material has a group II-VI compound, or Zn and at least one element selected from the group consisting of S, Se and Te.

**2.** The light-emitting diode according to claim 1, **characterized in that**
the ambipolar inorganic semiconductor material has a dopant concentration of 0.1% or less.

**3.** The light-emitting diode according to claim 1 or 2, **characterized in that**
a thickness of the inorganic light-emitting layer is 10 nm or more and 10 µm or less.

**4.** The light-emitting diode according to any one of claims 1 to 3, **characterized in that**
the n-type electrode includes a layer formed by use of an n-type inorganic semiconductor material in which an n-type dopant is diffused into the ambipolar inorganic semiconductor material.

**5.** The light-emitting diode according to any one of claims 1 to 3, **characterized in that**
the p-type electrode includes a layer formed by use of a p-type inorganic semiconductor material in which a p-type dopant is diffused into the ambipolar inorganic semiconductor material.

**6.** The light-emitting diode according to any one of claims 1 to 3, **characterized in that**
the n-type electrode includes a layer formed by use of an n-type inorganic semiconductor material in which an n-type dopant is diffused into the ambipolar inorganic semiconductor material, and the p-type electrode includes a layer formed by use of a p-type inorganic semiconductor material in which a p-type dopant is diffused into the ambipolar inorganic semiconductor material.

**7.** The light-emitting diode according to any one of claims 1 to 3, **characterized in that**
a material of a portion contacting the light-emitting layer in at least one of the n-type electrode and the p-type electrode is formed by use of a material substantially different from the material of the light-emitting layer.

**8.** The light-emitting diode according to any one of claims 1 to 7, **characterized in that**
an ambipolar inorganic semiconductor material is formed on a crystalline substrate or a glass substrate, and the n-electrode and the p-electrode are formed on the ambipolar inorganic semiconductor material so as not to contact each other.

**9.** The light-emitting diode according to any one of claims 1 to 7, **characterized in that**
the n-electrode or the p-electrode is formed on a crystalline substrate or a glass substrate, and an ambipolar inorganic semiconductor material is stacked thereon, and the p-electrode or the n-electrode is stacked thereon.
